# EUROPÄISCHE PATENTSCHRIFT

(11) **EP 3 123 564 B1**
(45) Veröffentlichungstag und Bekanntmachung des Hinweises auf die Patenterteilung: **26.09.2018**
(21) Anmeldenummer: 15713190.5
(22) Anmeldetag: 27.03.2015
(51) Int. Cl.: H01R 12/58, H01R 12/70

(54) **ELEKTRONIKBOX MIT EINER LEITERPLATTE UND EINEM ELEKTRISCHEN BAUTEIL SOWIE EINER KONTAKTIERUNGSVORRICHTUNG**
ELECTRONICS BOX WITH A PRINTED CIRCUIT BOARD AND AN ELECTRICAL COMPONENT PART, AND WITH A CONTACT-MAKING DEVICE
BOÎTIER ÉLECTRONIQUE AVEC UN CIRCUIT IMPRIMÉ ET UN COMPOSANT ÉLECTRIQUE, ET AVEC UN DISPOSITIF DE CONNEXION ÉLECTRIQUE

(30) Priorität: 27.03.2014 DE 102014104275
(43) Veröffentlichungstag der Anmeldung: 01.02.2017
(73) Patentinhaber: Eugen Forschner GmbH, 78549 Spaichingen (DE)
(72) Erfinder: BRANDT, Thomas, 78549 Spaichingen (DE); PUSKAS, Ludwig, 78549 Spaichingen (DE); ACKERMANN, Janosch, 78549 Spaichingen (DE)
(74) Vertreter: Wiese, Gerhard
(86) Internationale Anmeldenummer: PCT/EP2015/056789
(87) Internationale Veröffentlichungsnummer: WO 2015/144910

(56) Entgegenhaltungen:
- EP-A2- 0 548 810
- WO-A1-2013/041078
- DE-A1-102012 008 514
- DE-U1- 8 605 937
- DE-U1-202004 001 432
- DE-U1-202007 010 405

## Beschreibung

Die Erfindung betrifft eine Elektronikbox mit einer Leiterplatte und einem elektrischen Bauteil sowie einer Kontaktierungsvorrichtung zur Herstellung eines elektrischen Kontakts zwischen der in der Elektronikbox aufgenommenen Leiterplatte und dem elektrischen Bauteil gemäß dem Oberbegriff des Patentanspruchs 1.

Eine gattungsgemäße Elektronikbox ist aus der DE 10 2009 036 599 A1 bekannt. Die Elektronikbox wird dort von einem Verteilerkasten gebildet, in dem eine Leiterplatte den Batteriestrom eines Fahrzeugs auf verschiedene Leistungsstränge verteilt. Der Verteilerkasten beherbergt dort auch die Hauptsicherungen, die mit der Leiterplatte durch Verschrauben verbunden sind. Für eine Verschraubung der Sicherungen und anderer elektronischer Bauteile mit der Leiterplatte müssen die Maße der elektronischen Bauteile vorab exakt bekannt sein und zur exakten Herstellung der Kontakte die entsprechenden Bohrungen ebenso genau auf der Leiterplatte angeordnet werden. Die jeweilige Leiterplatte ist somit nur für einen ganz bestimmten Verteilerkasten eines speziellen Fahrzeugs geeignet. Insbesondere bei einer Anordnung der Elektronikbox im Motorraum eines Kraftfahrzeugs ist neben einer dauerhaft zuverlässigen Kontaktierung der elektronischen Bauteile mit der Leiterplatte auch die dichte Herausführung der Kontakte zur Batterie und zu den der Elektronikbox nachgeordneten Verteilersträngen eine wesentliche Anforderung, damit es nicht durch Lösen der Schrauben aufgrund von Schwingungen oder durch eindringende Feuchtigkeit oder Salz zu Leitungsunterbrechungen und damit zu Fehlern und Funktionsstörungen in der Bordelektrik kommt.

DE 20 2007 010405 U1 offenbart eine Elektronikbox gemäß dem Oberbegriff von Anspruch 1.

Aufgabe der Erfindung ist es, eine Kontaktierungsvorrichtung zu schaffen, die bei einer universelleren Verwendbarkeit einer Leiterplatte auch eine verbesserte Dichtigkeit ermöglicht.

Diese Aufgabe wird durch die Merkmale des Anspruchs 1 gelöst. Vorteilhafte Ausgestaltungen der Erfindung sind in den darauf bezogenen Unteransprüchen angegeben.

Dadurch, dass die Leiterplatte wenigstens eine Leiterfläche aufweist, die eine Vielzahl von in einem regelmäßigen Raster angeordneten Kontaktöffnungen aufweist, die zur Aufnahme von unterschiedlichen elektrischen Bauteilen mit einer jeweils unterschiedlichen Anzahl von Kontaktstiften ausgelegt sind, kann die Leiterplatte universell gestaltet und für eine Vielzahl möglicher Fahrzeuge verwendet werden.

Vorteilhaft sind die Kontaktstifte bezüglich ihrer Form und ihres Abstandes derart gestaltet, dass sie nur unter Anwendung eines Druckes als Einpresspins in die Kontaktöffnungen einfügbar sind. Die jeweiligen Bauteile sind dadurch einfacher montierbar und ihr dauerhafter mechanischer und elektrischer Kontakt ist gewährleistet.

Erfindungsgemäß ist vorgesehen, dass zwischen einem elektrischen Bauteil und der Leiterplatte ein mit Kontaktstiften versehenes, elektrisch leitendes Befestigungselement angeordnet ist. Ein solches als Kontaktbolzen ausgebildetes Befestigungselement dient mit seinem den Kontaktstiften gegenüberliegenden Ende dann zur Befestigung des elektronischen Bauteils bzw. zur Herausführung eines Kontaktes zur Außenseite der Elektronikbox.

Erfindungsgemäß ist weiterhin vorgesehen, dass der Kontaktbolzen an seinem den Kontaktstiften gegenüberliegenden Ende mit einem konisch ausgebildeten Mittelteil zur dichten Durchführung durch einen konisch ausgebildeten Durchbruch einer Wand der Elektronikbox versehen ist. Dadurch kann eine flüssigkeitsdichte und gegebenenfalls sogar eine gasdichte Durchführung der Kontakte durch die Wand der Elektronikbox erreicht werden. Zur Erhöhung der Dichtigkeit ist vorteilhaft vorgesehen, dass zwischen dem konisch ausgebildeten Mittelteil des Kontaktbolzens und dem konisch ausgebildeten Durchbruch der Wand ein Kleber oder eine Dichtmasse angeordnet ist.

Der Kontaktbolzen ist an seinem den Kontaktstiften gegenüberliegenden Ende bevorzugt mit einer Verbindungseinrichtung zur Befestigung eines elektrischen Leiters oder eines mit einem elektrischen Leiter verbundenen Anschlusselements versehen. Eine derartige Verbindungseinrichtung wird bevorzugt von einem Gewinde, von einer Crimphülse oder von einem Niet gebildet.

Die Erfindung ermöglicht eine Elektronikbox, die ein wenigstens eine Leiterplatte, die Befestigungselemente und die elektrischen Bauteil umschließendes Gehäuse aufweist, welches bei einem geringen Bauraum die Übertragung sehr hoher elektrischer Leistungen erlaubt.

Nachfolgend werden Ausführungsbeispiele einer erfindungsgemäßen Kontaktierungsvorrichtung unter Bezugnahme auf die Zeichnungen näher erläutert. Es zeigt:
- Fig. 1: eine schematische Ansicht einer Elektronikbox mit mehreren in einer oberen Wand einer wannenförmigen Abdeckung eines Gehäuses angeordneten Kontaktbolzen;
- Fig. 2: einen schematischen Längsschnitt durch einen Kontaktbolzen mit einer Crimphülse auf der Innenseite und dessen Aufnahme in der Wand gemäß der Schnittlinie II - II in Figur 1;
- Fig. 3: eine alternative Ausführungsform eines Kontaktbolzens mit einem Stecker auf der Innenseite;
- Fig. 4: eine schematische Teil-Darstellung einer mit einer Matrix von Kontaktöffnungen versehenen Leiterplatte;
- Fig. 5: eine schematische Darstellung einer Kontaktierung einer mittelgroßen Sicherung (MIDI-Fuse) an zwei unmittelbar benachbarten Kontaktbolzen,
- Fig. 6: eine schematische Darstellung einer Kontaktierung einer großen Sicherung (MEGA-Fuse) an zwei nicht unmittelbar benachbarten Kontaktbolzen,
- Fig. 7: einen schematischen Teil-Schnitt durch einen an der Unterseite einer Leiterplatte befestigten Kontaktbolzen mit einer von einem Gewinde gebildeten Befestigungseinrichtung,
- Fig. 8: einen schematischen Teil-Schnitt durch einen von der Oberseite einer Leiterplatte befestigten Kontaktbolzen mit einer von einem Niet gebildeten Befestigungseinrichtung,
- Fig. 9: eine teilweise aufgebrochene perspektivische Darstellung einer Elektronikbox mit mehreren Einpressmuttern und Kontaktbolzen als Befestigungselemente und mit von Steckern gebildeten Anschlusselementen,
- Fig. 10: die Elektronikbox gemäß Figur 9 in einer anderen Darstellung;
- Fig.11: die komplett bestückte Leiterplatte der Elektronikbox gemäß den Figuren 9 und 10 in perspektivische Darstellung, und
- Fig. 12: die komplett bestückte Leiterplatte gemäß Figur 11 in einer Draufsicht.

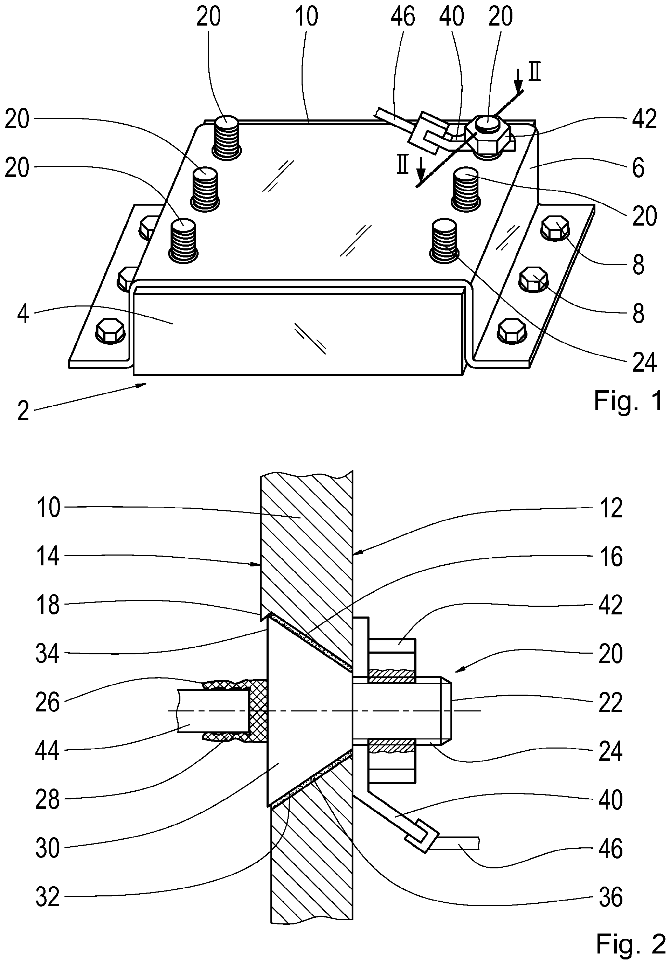

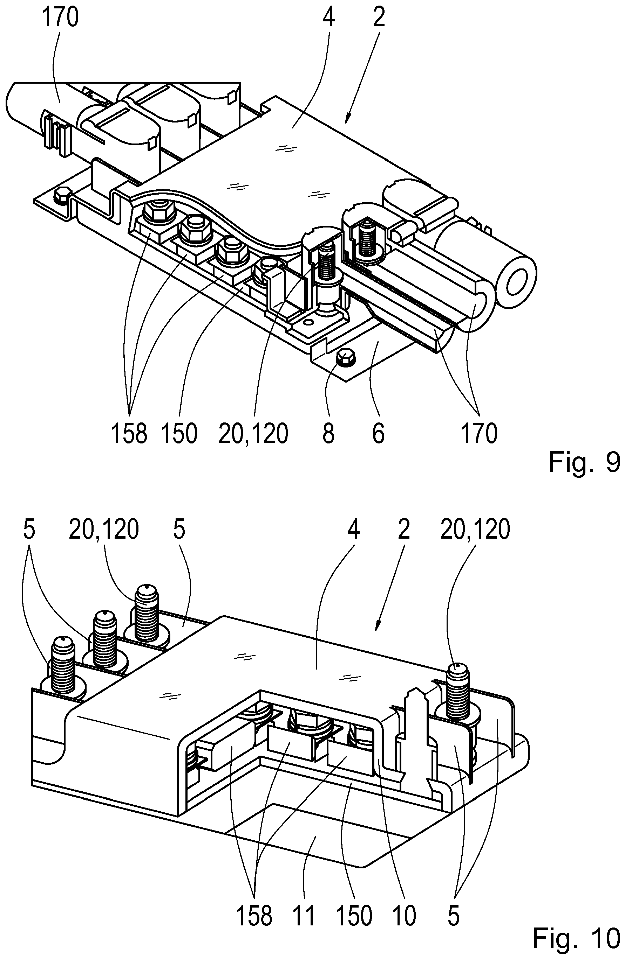

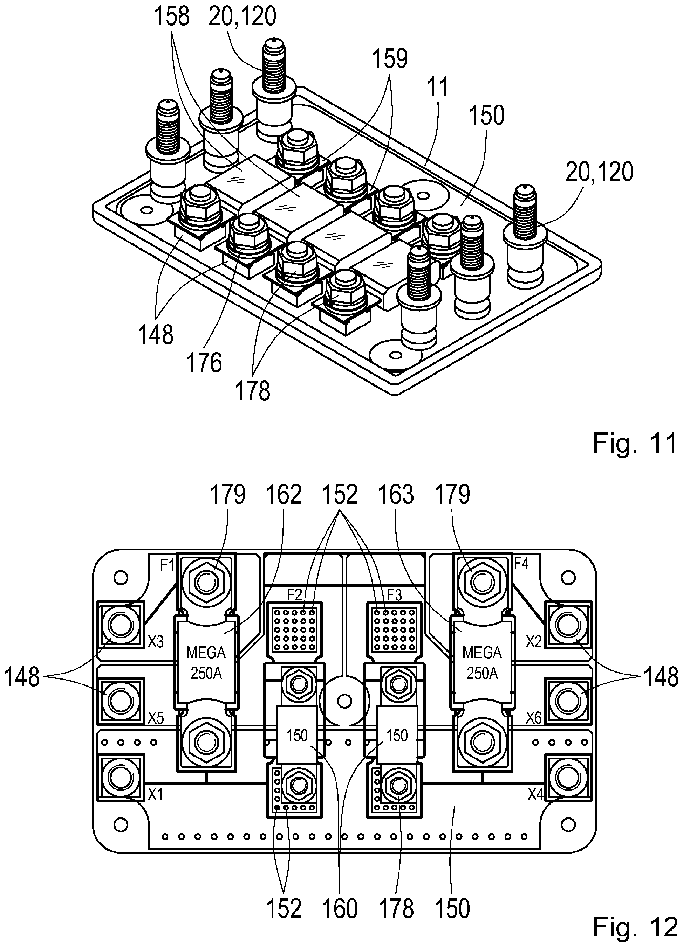

Eine in Fig. 1 schematisch dargestellte Elektronikbox 2 weist ein Gehäuse 4 mit wenigstens einer Wand 10, 11 auf. Die Wand 11 ist, wie in Figur 11 dargestellt, als flache Wanne mit einem erhabenen Rand ausgebildet, wobei die flache Wanne zur Aufnahme einer Leiterplatte 150 dient. Die Wand 10 ist Bestandteil einer wannenförmigen Abdeckung und bildet in Verbindung mit der Wand 11 das Gehäuse 4 der Elektronikbox 2 Die Elektronikbox 2 dient, wie insbesondere aus den Figuren 9 bis 11 ersichtlich, der Aufnahme der Leiterplatte 150, die insbesondere zur Absicherung und zur Verteilung von Leistungsströmen von einer Fahrzeugbatterie zu nachgeordneten elektrischen Verbrauchern dient.

Das Gehäuse 4 der Elektronikbox 2 besteht aus einem elektrisch nicht leitenden Material, beispielsweise aus einem Kunststoff, wie Polyamid (PA). Durch die insbesondere in Figur 10 erkennbare Verrippung 5 mit mehreren Längs- und Querrippen weist das Gehäuse 4 trotz einer Verwendung von Kunststoff eine hohe mechanische Stabilität auf.

Die Elektronikbox 2 ist im Ausführungsbeispiel beispielsweise mittels eines über der wannenförmigen Abdeckung angeordneten Sicherungsblechs 6 und in dessen abgewinkelten Randbereichen angeordneten Schrauben 8 an einer Spritzwand im Motorraum eines Kraftfahrzeugs befestigt. In der oberen Wand 10 der wannenförmigen Abdeckung sind mehrere Kontaktbolzen 20 angeordnet, die auf einer ersten Seite 12 - nämlich in diesem Fall auf der Außenseite der Wand 10 - mit einem Gewinde 24 versehen sind. Am Gewinde 24 ist beispielsweise - wie exemplarisch an einem der Kontaktbolzen 20 rechts oben angedeutet - ein Kabelschuh 40 mittels einer Mutter 42 befestigt. Der Kabelschuh 40 ist seinerseits mit einem elektrischen Leiter 46 verbunden, der zu einem elektrischen Verbraucher führt.

Der Kontaktbolzen 20 ist in einer vergrößerten Schnittansicht in Fig. 2 dargestellt. Der Kontaktbolzen 20 weist anschließend an das Gewinde 24 an seinem ersten Ende 22 ein Mittelteil 30 auf, das von einem ausgehend vom unteren Ende des Gewindes 24 sich erweiternden Konus 32 gebildet wird. Anschließend an den Konus 32 weist der Kontaktbolzen 20 an seinem anderen Ende 26 eine Crimphülse 28 auf, die zur Kontaktierung mit einem elektrischen Leiter 44 auf der Innenseite 14 der Wand 10 dient. Nach Einführen des abisolierten Endes des Leiters 44 wird die Crimphülse 28 mittels einer Crimpzange in bekannter Weise verformt, so dass eine dauerhafte formschlüssige und gut leitende Verbindung zwischen dem Kontaktbolzen 20 und dem Leiter 44 gewährleistet ist.

Für eine wasserdichte und sogar in hohem Maße gasdichte Durchführung des Kontaktbolzens 20 durch einen Durchbruch 16 in der Wand 10 ist erfindungsgemäß vorgesehen, dass der Durchbruch 16 eine an den Konus 32 des Kontaktbolzens angepasste konische Form aufweist. Der Konus 32 wird dabei durch Anziehen der Mutter 42 fest gegen die konische Wand des Durchbruchs 16 gezogen. Er weist eine große Dichtfläche auf. Die Dichtigkeit kann durch Einbringen einer Dichtmasse oder eines Klebers 36 in den Spalt zwischen Konus 32 und Durchbruch 16 vor dem Anziehen der Mutter 42 optional noch erhöht werden. Für eine zumindest vorläufige Fixierung der Kontaktbolzen 20 in den Durchbrüchen 16 sind vorteilhaft Rastnasen 18 im Randbereich der Wand 10 vorgesehen, die mit Rastvorsprüngen 34 zusammenwirken.

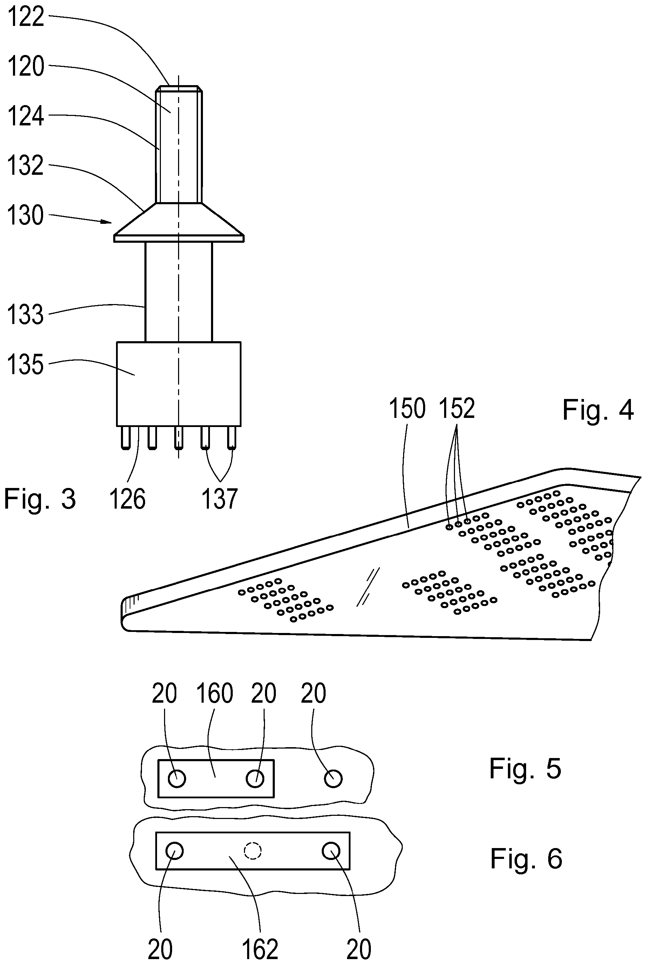

In Figur 3 ist eine alternative Ausführungsform eines Kontaktbolzens 120 dargestellt. Dieser weist an einem ersten Ende 122 wiederum ein Gewinde 124 auf, an das sich nach unten in einem Mittelteil 130 ein Konus 132 anschließt. An den Konus 132 schließt sich nach unten ein zylindrisches Distanzstück 133 an. Am anderen Ende 126 ist abweichend von der ersten Ausführungsform gemäß Figur 2 ein Stecker 135 angeordnet, der mit mehreren Kontaktstiften 137 versehen ist.

Die Kontaktstifte 137 dienen zur Verbindung mit Kontaktöffnungen 152, die in einer in Figur 4 dargestellten Leiterplatte 150 angeordnet sind. Die Kontaktstifte 137 dienen einerseits zu einer dauerhaften mechanischen Fixierung des Steckers 135 an der Leiterplatte 150. Sie dienen andererseits aber auch zur elektrischen Kontaktierung des Kontaktbolzens 120 mit Leiterbahnen oder Leiterflächen auf der Leiterplatte 150, die ihrerseits mit den Kontaktöffnungen 152 elektrisch leitend verbunden sind. Die Leiterplatte 150 kann dabei vorteilhaft übereinanderliegend und elektrisch gegeneinander isoliert mehrere Leiterflächen aufweisen. Kontaktstifte 137 und Kontaktöffnungen 152 sind vorzugsweise jeweils in einer fest aufeinander abgestimmten, sich mehrfach auf der Platine 150 wiederholenden Matrix angeordnet. Im Ausführungsbeispiel ist eine Matrix von jeweils 5 x 5 Kontaktstiften 137 bzw. Kontaktöffnungen 152 dargestellt.

Auch die Kontaktbolzen 20 bzw. 120 sind bevorzugt in gleichmäßigen Abständen in einer Wand 10 des Gehäuses 4 angeordnet. Sie können bei gleichem Konus 32 bzw. 132 mit unterschiedlichen Gewinden 24 bzw. 124 (beispielsweise mit einem Gewinde der Größe M6 oder mit einem Gewinde der Größe M8 versehen sein. Der Durchmesser des jeweiligen Gewindes 24 bzw. 124 trägt somit sowohl unterschiedlichen daran zu fixierenden Bauteilen als auch unterschiedlichen an die jeweiligen Bauteile zu übertragenden elektrischen Leistungen Rechnung.

Die Kontaktbolzen 20, 120 können auch in die Wände 10 unmittelbar eingepresst werden, wobei Kleber oder Dichtmasse 36 auch hier für eine erhöhte Dichtigkeit sorgen. Die Gewinde 24, 124 müssen dann nicht im Zusammenwirken mit den Muttern 42 zur Fixierung des Konus 32, 132 in der Wand 10 dienen, da durch das Einpressen der Kontaktbolzen bereits eine materialschlüssige Verbindung zur Wand 10 hergestellt ist.

In den Figuren 5 und 6 sind exemplarisch zwei unterschiedlich große Sicherungen 160 bzw. 162 an benachbarten Kontaktbolzen 20 befestigt. In Figur 5 ist eine mittelgroße Sicherung 160 (von Fachleuten in der Fahrzeugindustrie auch als "MIDI-Fuse" bezeichnet) an zwei unmittelbar benachbarten Kontaktbolzen 20 befestigt und kontaktiert. Für diese Sicherungen 160 werden beispielsweise Kontaktbolzen 20 mit M6-Gewinden 24, 124 verwendet. In Figur 6 ist eine demgegenüber größere Sicherung 162 (von Fachleuten in der Fahrzeugindustrie auch als "MEGA-Fuse" bezeichnet) an zwei nicht unmittelbar benachbarten Kontaktbolzen 20 befestigt und kontaktiert. Hier wird aufgrund der Größe der Sicherung wenigstens ein dazwischen liegender Kontaktbolzen 20 bzw. ein für diesen vorgesehener Durchbruch 16 im Gehäuse übergangen. Für die größere Sicherung 162 können die Kontaktbolzen 20 beispielsweise mit M8-Gewinden versehen sein.

Ein wesentliches Merkmal der vorliegenden Erfindung ist, dass die Leiterplatte 150 wenigstens eine Leiterfläche F1, F2, F3, F4 (siehe Figur 12) aufweist, die eine Vielzahl von in einem regelmäßigen Raster angeordneten Kontaktöffnungen 152 aufweist, die zur Aufnahme von unterschiedlichen elektrischen Bauteilen 160, 162, 163 mit einer jeweils unterschiedlichen Anzahl von Kontaktstiften 137, 138, 144 ausgelegt sind.

De Kontaktstifte 137, 138, 144 sind bezüglich ihrer Form und ihres Abstandes derart gestaltet sind, dass sie nur unter Anwendung eines Druckes als Einpresspins in die Kontaktöffnungen 152 einfügbar sind.

Wie insbesondere aus Figur 12 ersichtlich, ist das Raster der Kontaktöffnungen 152 auf den Leiterflächen F1, F2, F3, F4 bei den beiden innen liegenden Kontaktfeldern F2 und F3 im gezeigten Ausführungsbeispiel von einem kleineren elektronischen Bauteil 158 bestückt, in diesem Fall von einer MIDI-Sicherung 160, wobei zur Kontaktierung der beiden Seiten der MIDI-Sicherung 160 mit den Kontaktfeldern F2 und F3 der Leiterplatte 150 kleinere Einpressmuttern 148 verwendet werden mit einer geringeren Zahl von Kontaktstiften 137, so dass ein Teil der Kontaktöffnungen 152 unbenutzt bleibt. Im dargestellten Ausführungsbeispiel belegen die kleineren Einpressmuttern 148 mit 16 Kontaktstiften 137 ein Raster von 4 × 4 Kontaktöffnungen, so dass 9 Kontaktöffnungen 152 an zwei äußeren Rändern unbenutzt bleiben. Die MIDI-Sicherung 160 ist zur Absicherung von Strömen bis 150 A geeignet.

Auf den weiter außen liegenden Leiterflächen F1 und F4 sind dagegen MEGA-Sicherungen 162, 163 angeordnet, die eine höhere Absicherung für Ströme bis 250 A gewährleisten. Für die höheren Ströme werden größere Einpressmuttern 158 verwendet, die beispielsweise 25 Kontaktstifte 137 in einem Raster von 5 × 5 aufweisen und somit sämtliche Kontaktöffnungen 152 eines gerasterten Kontaktfeldes belegen.

MIDI-Sicherungen 160 und -Sicherungen 162, 163 sind durch elektrisch leitende Laschen 159 mit den Einpressmuttern 148 in Kontakt. Über Federringe 176 und Muttern 178 bzw. 179 erfolgt eine dauerhafte mechanische und elektrische Kontaktierung.

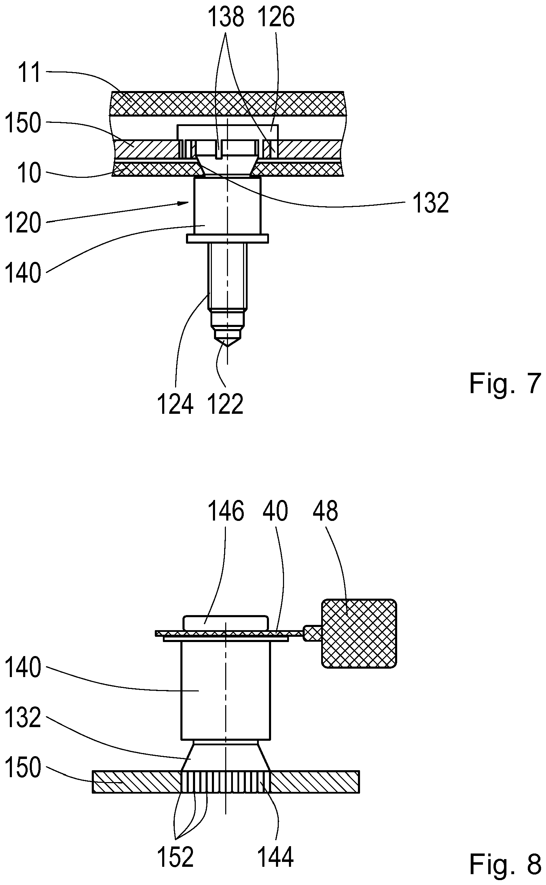

Die Kontaktstifte 137 gemäß Figur 3, die Einpresszapfen 138 gemäß Figur 7 und die Einpresspins 144 gemäß Figur 8 sind bezüglich ihrer Form und ihres Abstandes zueinander so gewählt, dass sie sich nur unter einem bestimmten Druck in die Kontaktöffnungen 152 einfügen lassen. Kontaktstifte 137, Einpresszapfen 138 und Einpresspins 144 weisen beispielsweise einen quadratischen oder sechseckigen Querschnitt mit einem gegenüber den Kontaktöffnungen 152 leichten Übermaß auf. Mittels angeschliffener Spitzen lassen Sie sich in die Kontaktöffnungen 152 einführen und unter Druck in diese hineinpressen. Dabei geraten die äußeren Mantelflächen der Kontaktstifte 137, Einpresszapfen 138 und Einpresspins 144 in einen dauerhaften mechanisch festen und elektrisch leitenden Kontakt mit den Kontaktöffnungen 152.

Die Kontaktstifte 137 des Kontaktbolzens 120 gemäß Figur 3 und die Einpresspins 144 des Kontaktbolzens gemäß Figur 8 werden von oben in Kontaktöffnungen 152 der Leiterplatte 150 eingepresst. In Figur 8 ist mittels eines Nietes 146 ein Kabelschuh 40 befestigt, der unmittelbar mit einem elektronischen Anbauteil 48 verbunden ist.

Die Einpresszapfen 138 des Kontaktbolzens 120 gemäß Figur 7 werden dagegen von der Unterseite der Leiterplatte 150 in dieser eingepresst. Die Fixierung an der Leiterplatte 150 erfolgt dort durch dichte Anlage eines am Kontaktbolzen 120 ausgebildeten Konus 132 an den Wänden eines konischen Durchbruchs einer Wand 10 des Gehäuses 4 und eine Presshülse 140 mit zwei nicht dargestellten, unter Druck gegeneinander verschiebbaren und verkeilbaren konischen Klemmflächen.

Während eine Verbindungseinrichtung an einem äußeren Ende eines Kontaktbolzens 20 gemäß Figur 2 von einer Crimphülse 28 gebildet wird, wird die Verbindungseinrichtung am äußeren Ende des Kontaktbolzens 120 gemäß Figur 3 von einem Gewinde 24 und die Verbindungseinrichtung am äußeren Ende des Kontaktbolzens gemäß Figur 8 von einem Niet 146 gebildet wird.

Die Kontaktierung der Leiterplatte 150 nach außen erfolgt über in den Figuren 1 und 9 bis 12 dargestellte Kontaktbolzen 20 bzw. 120. Diese sind an den äußeren beiden Rändern der Leiterplatte 150 in den dort bezeichneten Kontaktfeldern X1, X2, X3, X4, X5, und X6 befestigt. Die Verbindung vom äußeren Ende der Kontaktbolzen 20 bzw. 120 zur Fahrzeugbatterie oder zu benachbarten Stromkreisen von elektrischen Verbrauchern des Fahrzeugs wird bevorzugt durch wasserdichte oder zumindest vor Spritzwasser geschützte Stecker 170 (Figur 9) hergestellt.

Durch die erfindungsgemäße Kontaktierungsvorrichtung wird eine dauerhaft sichere, äußerst kompakte Anordnung einer eingangsseitigen Kontaktierung einer Spannungsversorgung und einer ausgangsseitigen Verbindung mit elektrischen Verbrauchern ermöglicht. Dabei können elektronische Bauteile zusätzlich geschützt innerhalb eines aufgrund der wasser- und gasdichten Durchführungen der Kontaktbolzen dichten Gehäuses 4 einer Elektronikbox 2 angeordnet werden.

Die erfindungsgemäße Kontaktierungsvorrichtung ermöglicht eine Elektronikbox, die ein wenigstens eine Leiterplatte, die Befestigungselemente und die elektrischen Bauteil umschließendes Gehäuse aufweist, welches bei einem geringen Bauraum die Übertragung sehr hoher elektrischer Leistungen erlaubt. So konnte bei einem Versuch bei einer Bordspannung von 24 V und von 48 V bereits erfolgreich ein Stromeingang von 500 A und ein Slave-Eingang von 500 A mit 4 Sicherungen von jeweils zwischen 150 und 250 A in einer Elektronikbox mit einer Länge von 160 mm, einer Breite von 110 mm und einer Höhe von 39 mm untergebracht werden. Eine der Art hohe Kompaktheit und Leistungsdichte konnte bisher bei keiner bekannten Kontaktierungsvorrichtung erreicht werden.

Bevorzugte Anwendungen einer erfindungsgemäßen Kontaktierungsvorrichtung und Elektronikbox sind Sicherungs- oder Verteilerboxen in einem Kraftfahrzeug, insbesondere in einem Personenkraftwagen oder in einem Nutzfahrzeug. Es versteht sich für den Fachmann jedoch, dass die vorliegende Erfindung auch zur Kontaktierung anderer elektronischer Bauteile hervorragend geeignet ist.

**Bezugszeichenliste**

| | | | |
|---|---|---|---|
| 2 | Elektronikbox | 124 | Gewinde (an 122) |
| 4 | Gehäuse | 126 | zweites Ende (von 120) |
| 5 | Verrippung | 130 | Mittelteil |
| 6 | Sicherungsblech | 132 | Konus |
| 8 | Schraube | 133 | Distanzstück |
| 10 | Wand (von 4) | 135 | Stecker |
| 11 | Wand (von 4) | 137 | Kontaktstift |
| 12 | erste Seite (von 10) | 138 | Einpresszapfen |
| 14 | zweite Seite (von 10) | 140 | Presshülse |
| 16 | Durchbruch (in 10) | 144 | Einpresspins |
| 18 | Rastnase (an 10) | 146 | Niet |
| 20 | Kontaktbolzen | 148 | Einpressmutter |
| 22 | erstes Ende (von 20) | 150 | Leiterplatte |
| 24 | Gewinde (an 22) | 152 | Kontaktöffnung |
| 26 | zweites Ende (von 20) | 158 | Bauteil |
| 28 | Crimphülse (an 26) | 159 | Lasche |
| 30 | Mittelteil | 160 | MIDI-Sicherung |
| 32 | Konus | 162 | MEGA-Sicherung |
| 34 | Rastvorsprung | 163 | MEGA-Sicherung |
| 36 | Kleber (oder Dichtmasse) | 170 | Stecker |
| 40 | Kabelschuh | 176 | Federring |
| 42 | Mutter | 178 | Mutter |
| 44 | Leiter | 179 | Mutter |
| 46 | Leiter | | |
| 48 | Anbauteil | | |
| 120 | Kontaktbolzen | | |
| 122 | erstes Ende (von 120) | | |

## Patentansprüche

1. Elektronikbox (2) mit einer Leiterplatte (150) und einem elektrischen Bauteil (160, 162, 163), sowie einer Kontaktierungsvorrichtung zur Herstellung eines elektrischen Kontakts zwischen der in der Elektronikbox (2) aufgenommenen Leiterplatte (150) und dem elektrischen Bauteil (160, 162, 163), wobei die Leiterplatte (150) wenigstens eine Leiterfläche (F1, F2, F3, F4) mit wenigstens einer Kontaktöffnung (152) zur Aufnahme wenigstens eines am elektronischen Bauteil (160, 162, 163) angeordneten Kontaktstiftes (137; 144) aufweist, wobei die Leiterfläche (F1, F2, F3, F4) eine Vielzahl von in einem regelmäßigen Raster angeordneten Kontaktöffnungen (152) aufweist, die zur Aufnahme von unterschiedlichen elektrischen Bauteilen (160, 162, 163) mit einer jeweils unterschiedlichen Anzahl von Kontaktstiften (137; 138; 144) ausgelegt sind, wobei zwischen dem elektrischen Bauteil (160, 162, 163) und der Leiterplatte (150) ein mit Kontaktstiften (137; 138; 144) versehener, als elektrisch leitendes Befestigungselement (120; 148; 158) dienender Kontaktbolzen (120) angeordnet ist, **dadurch gekennzeichnet, dass** der Kontaktbolzen (120) an seinem den Kontaktstiften (137; 138; 144) gegenüberliegenden Ende mit einem konisch ausgebildeten Mittelteil (30) zur dichten Durchführung durch einen konisch ausgebildeten Durchbruch (16) einer Wand (10) der Elektronikbox (2) versehen ist.

2. Elektronikbox nach Anspruch 1, **dadurch gekennzeichnet, dass** die Kontaktstifte (137; 138; 144) bezüglich ihrer Form und ihres Abstandes derart gestaltet sind, dass sie nur unter Anwendung eines Druckes als Einpresspins in die Kontaktöffnungen (152) einfügbar sind.

3. Elektronikbox nach einem der vorhergehenden Ansprüche, **dadurch gekennzeichnet, dass** zwischen dem konisch ausgebildeten Mittelteil (30) des Kontaktbolzens (120) und dem konisch ausgebildeten Durchbruch (16) der Wand (10) ein Kleber oder eine Dichtmasse (36) angeordnet ist.

4. Elektronikbox nach einem der vorhergehenden Ansprüche, **dadurch gekennzeichnet, dass** der Kontaktbolzen (120) an seinem den Kontaktstiften (137; 144) gegenüberliegenden Ende mit einer Verbindungseinrichtung (24; 28; 146) zur Befestigung eines elektrischen Leiters (44; 46) oder eines mit einem elektrischen Leiter (44; 46) verbundenen Anschlusselements (40; 146; 170) versehen ist.

5. Elektronikbox nach Anspruch 4, **dadurch gekennzeichnet, dass** die Verbindungseinrichtung von einem Gewinde (24), von einer Crimphülse (28) oder von einem Niet (146) gebildet wird.

6. Elektronikbox nach Anspruch 4 und 5, **dadurch gekennzeichnet, dass** das Anschlusselement von einem Kabelschuh (40) oder von einem Stecker (170) gebildet wird.

7. Elektronikbox nach einem der vorhergehenden Ansprüche, **dadurch gekennzeichnet, dass** die Elektronikbox (2) ein die Leiterplatte (150), die Befestigungselemente (120; 148; 158) und die elektrischen Bauteile (160, 162, 163) umschließendes Gehäuse (4) aufweist, welches bei einem geringen Bauraum die Übertragung sehr hoher elektrischer Leistungen ermöglicht.

8. Elektronikbox nach Anspruch 7, **dadurch gekennzeichnet, dass** in der Elektronikbox (2) mit einer Länge von 160 mm, einer Breite von 110 mm und einer Höhe von 39 mm bei einer Bordspannung von 24 V und von 48 V ein Stromeingang von 500 A und ein Slave-Eingang von 500 A mit vier Sicherungen von jeweils zwischen 150 und 250 A angeordnet sind.

9. Verwendung einer Elektronikbox (2) gemäß einem der vorhergehenden Ansprüche als Sicherungs- oder Verteilerbox in einem Kraftfahrzeug.

## Claims

1. Electronics box (2) comprising a circuit board (150) and an electrical component (160, 162, 163), and comprising a contacting apparatus for establishing an electrical contact between the circuit board (150) accommodated in the electronics box (2) and the electrical component (160, 162, 163), the circuit board (150) comprising at least one conductor surface (F1, F2, F3, F4) which has at least one contact opening (152) for receiving at least one contact pin (137; 144) arranged on the electronic component (160, 162, 163), the conductor surface (F1, F2, F3, F4) comprising a plurality of contact openings (152) that are arranged in a regular grid and designed to receive different electrical components (160, 162, 163) each having a different number of contact pins (137; 138; 144), a contact bolt (120) which is provided with contact pins (137; 138; 144) and used as an electrically conductive securing element (120; 148; 158) being arranged between the electrical component (160, 162, 163) and the circuit board (150), **characterized in that** the contact bolt (120), at the end thereof that is opposite the contact pins (137; 138; 144), is provided with a conical central part (30) for being sealingly guided through a conical aperture (16) in a wall (10) of the electronics box (2).

2. Electronics box according to claim 1, **characterized in that** the contact pins (137; 138; 144), with respect to their shape and spacing, are designed in such a way that they can be inserted into the contact openings (152) as press-in pins only when pressure is applied.

3. Electronics box according to either of the preceding claims, **characterized in that** an adhesive or a sealant (36) is arranged between the conical central part (30) of the contact bolt (120) and the conical aperture (16) in the wall (10).

4. Electronics box according to any of the preceding claims, **characterized in that** the contact bolt (120), at the end thereof that is opposite the contact pins (137; 144), is provided with a connecting device (24; 28; 146) for securing an electrical conductor (44; 46) or securing a connection element (40; 146; 170) connected to an electrical conductor (44; 46).

5. Electronics box according to claim 4, **characterized in that** the connecting device is formed by a screw thread (24), a crimp sleeve (28) or a rivet (146).

6. Electronics box according to either claim 4 or claim 5, **characterized in that** the connection element is formed by a cable lug (40) or a plug (170).

7. Electronics box according to any of the preceding claims, **characterized in that** the electronics box (2) comprises a housing (4) which surrounds the circuit board (150), the securing elements (120; 148; 158) and the electrical components (160, 162, 163) and allows very high electrical powers to be transmitted in a small installation space.

8. Electronics box according to claim 7, **characterized in that** a current input of 500 A and a slave input of 500 A, together with four fuses, each of between 150 and 250 A, are arranged in the electronics box (2) which has a length of 160 mm, a width of 110 mm, a height of 39 mm and an on-board voltage of 24 V and 48 V.

9. Use of an electronics box (2) according to any of the preceding claims as a fuse box or a distributor box in a motor vehicle.

## Revendications

1. Boîtier électronique (2) doté d'un circuit imprimé (150) et d'un composant électrique (160, 162, 163), ainsi que d'un dispositif de contact destiné à établir un contact électrique entre le circuit imprimé (150) logé dans le boîtier électronique (2) et le composant électrique (160, 162, 163), le circuit imprimé (150) possédant au moins une surface conductrice (F1, F2, F3, F4) dotée d'au moins une ouverture de contact (152) destinée à recevoir au moins une broche de contact (137 ; 144) agencée au niveau du composant électronique (160, 162, 163), la surface conductrice (F1, F2, F3, F4) comportant une pluralité d'ouvertures de contact (152) agencées suivant une trame régulière, lesquelles sont conçues pour recevoir différents composants électriques (160, 162, 163) comportant chacun un nombre différent de broches de contact (137 ; 138 ; 144), un boulon de contact (120), pourvu de broches de contact (137 ; 138 ; 144) et servant d'élément de fixation (120 ; 148 ; 158) électriquement conducteur, étant agencé entre le composant électrique (160, 162, 163) et le circuit imprimé (150), **caractérisé en ce que** le boulon de contact (120) est pourvu, à son extrémité faisant face aux broches de contact (137 ; 138 ; 144), d'une partie centrale (30) de forme conique, destinée à être insérée de manière étanche dans un passage (16) de forme conique d'une paroi (10) du boîtier électronique (2).

2. Boîtier électronique selon la revendication 1, **caractérisé en ce que** les broches de contact (137 ; 138 ; 144) sont formées, relativement à leur forme et à leur espacement, de manière à pouvoir être insérées comme broches d'insertion dans les ouvertures de contact (152) que par application d'une pression.

3. Boîtier électronique selon l'une des revendications précédentes, **caractérisé en ce qu'**un adhésif ou une matière d'étanchéité (36) est placé entre la partie centrale (30) de forme conique du boulon de contact (120) et le passage (16) de forme conique de la paroi (10).

4. Boîtier électronique selon l'une des revendications précédentes, **caractérisé en ce que** le boulon de contact (120) est pourvu, à son extrémité faisant face aux broches de contact (137 ; 138 ; 144), d'un dispositif de connexion (24 ; 28 ; 146) destiné à fixer un conducteur électrique (44 ; 46) ou un élément de raccordement (40 ; 146 ; 170) connecté à un conducteur électrique (44 ; 46).

5. Boîtier électronique selon la revendication 4, **caractérisé en ce que** le dispositif de connexion est formé par un filetage (24), un manchon de sertissage (28) ou un rivet (146).

6. Boîtier électronique selon les revendications 4 et 5, **caractérisé en ce que** l'élément de raccordement est formé par une cosse de câble (40) ou une fiche mâle (170).

7. Boîtier électronique selon l'une des revendications précédentes, **caractérisé en ce que** le boîtier électronique (2) comporte un carter (4) contenant le circuit imprimé (150), les éléments de fixation (120 ; 148 ; 158) et les composants électriques (160, 162, 163), lequel carter permet la transmission de puissances électriques très élevées pour un encombrement est réduit.

8. Boîtier électronique selon la revendication 7, **caractérisé en ce qu'**une entrée de courant de 500 A et une entrée esclave de 500 A comportant quatre fusibles, de 150 à 250 A chacun, sont disposées dans le boîtier électronique (2) d'une longueur de 160 mm, d'une largeur de 110 mm et d'une hauteur de 39 mm, pour une tension de bord de 24 V et de 48 V.

9. Utilisation d'un boîtier électronique (2) selon l'une des revendications précédentes comme boîtier de fusible ou boîtier répartiteur dans un véhicule à moteur.
